# EUROPEAN PATENT APPLICATION

(11) **EP 4 397 982 A1**
(43) Date of publication of application: **10.07.2024**
(21) Application number: 23745896.3
(22) Date of filing: 09.01.2023
(51) Int. Cl.: G01R 1/06, G01R 31/364, H01M 50/569, H01M 10/48

(54) **SAMPLING APPARATUS, BATTERY, AND ELECTRICAL DEVICE**

(30) Priority: 25.01.2022 CN 202220202317 U
(71) Applicant: Contemporary Amperex Technology Co., Limited, Ningde, Fujian 352100 (CN)
(72) Inventor: WANG, Chong, Ningde, Fujian 352100 (CN); CHEN, Zhiming, Ningde, Fujian 352100 (CN); ZHENG, Chenling, Ningde, Fujian 352100 (CN)
(74) Representative: Rowlands, Stuart Michael
(86) International application number: PCT/CN2023/071346
(87) International publication number: WO 2023/143013

(57) **Abstract**

A sampling apparatus (100), a battery, and an electrical device. The sampling apparatus (100) comprises a sampling circuit board (110), the sampling circuit board (110) has a first sampling line (111) and a second sampling line (112), and the first sampling line (111) and the second sampling line (112) are used for collecting different operating parameters of a battery module; a surface of at least one of the first sampling line (111) and second sampling line (112) is provided with a continuous or discontinuous protection layer; a signal output portion (113) is provided on the sampling circuit board (110), and the first sampling line (111) and the second sampling line (112) are each connected to the signal output portion (113). The surface of at least one of the first sampling line (111) and the second sampling line (112) is completely provided with a protective layer, making it so that, of the first sampling line (111) and second sampling line (112), at least a sampling circuit used for collecting temperature signals has a protective layer formed over the entire surface thereof, the protective layer satisfying the oxidation resistance requirements of the sampling circuit. The method for the surface treatment of the entire sampling circuit is not limited by the structure of a connecting part, thus avoiding the problem that the complexity of the treatment process is increased due to limitations from the structure of the connecting part.

## Description

The present application claims priority to Chinese Patent Application No. 202220202317.3, filed with the China National Intellectual Property Administration on January 25, 2022, and entitled "SAMPLING DEVICE, BATTERY AND POWER CONSUMING APPARATUS", which is incorporated herein by reference in its entirety.

### Technical Field

The present application relates to the field of traction batteries, and in particular to a sampling device, a battery and a power consuming apparatus.

### Background Art

Information provided in this section is only background information related to the present application, which is not necessarily the prior art.

In order to ensure the safety performance and service life of a battery, it is necessary to measure parameters such as a voltage and a temperature of the battery, so as to know a working state of the battery in a timely manner. In the related art, a sampling device of the battery has a complex structural composition and an inconvenient installation, which affects the production efficiency of the battery.

### Technical Problem

An objective of the present application is to provide a sampling device, a battery and a power consuming apparatus, to solve the problems of complex structural composition and inconvenient installation of the sampling device of the battery.

### Technical Solutions

The specific technical solutions are as follows.

In a first aspect, an embodiment of the present application provides a sampling device, including a sampling circuit board. The sampling circuit board has a first sampling wire and a second sampling wire, wherein the first sampling wire and the second sampling wire are configured to acquire different working parameters of a battery module, a continuous or discontinuous protective layer is provided on a surface of at least one of the first sampling wire and the second sampling wire, a signal output portion is provided on the sampling circuit board, and the first sampling wire and the second sampling wire are both connected to the signal output portion.

In the sampling device according to the embodiment of the present application, the sampling circuit board of the sampling device includes the first sampling wire and the second sampling wire, after being connected to the battery module, the first sampling wire and the second sampling wire can acquire different working parameters of the battery module, and the acquired sampling signals corresponding to the working parameters of the battery module are transmitted to a management system of the battery module via the signal output portion. The battery module various working parameters such as a voltage parameter and a temperature parameter. Accordingly, there are also different requirements for the structural characteristics of the connections of the first sampling wire and the second sampling wire to the battery module to acquire different working parameters of the battery module. When the temperature parameter is required to be acquired, it is required that the connection of a sampling line to the battery module should have oxidation resistance and other characteristics. In the embodiment of the present application, the continuous or discontinuous protective layer is provided on the surface of at least one of the first sampling wire and the second sampling wire, so that at least one of the first sampling wire and the second sampling wire includes a sampling line for acquiring a temperature signal, and prior to being connected to the battery module, the entire sampling line is protected, thereby forming the protective layer, which can meet the requirement of oxidation resistance for the sampling line, on its surface. Compared with the way of surface treatment only for a connection portion of the sampling line to the battery module, the way of surface treatment for the entire sampling line is not limited by the structure of the connection portion, thereby avoiding the problem of an increased complexity of a treatment process due to the structural limitation of the connection portion. Therefore, the installation of the sampling device is facilitated and the production efficiency of the battery is improved.

In addition, the sampling device according to the embodiment of the present application can further have the following additional technical features.

In some embodiments of the present application, the first sampling wire is configured to acquire a voltage signal of the battery module, and the first sampling wire is a bare metal wire. The bare metal wire has good electrical conductivity and physical and mechanical properties, and the bare metal wire is also easy to be welded to the battery module.

In some embodiments of the present application, the second sampling wire is configured to acquire a temperature signal of the battery module, and the protective layer is provided on the surface of the second sampling wire. The protective layer can protect the second sampling wire, so that the oxidation resistance of the second sampling wire is improved and the service life of the second sampling wire is prolonged.

In some embodiments of the present application, the protective layer is a tin-plated layer or a gold-plated layer. The tin-plated layer or the gold-plated layer can improve the oxidation resistance and corrosion resistance of the second sampling wire, and the tin plating or gold plating has a low cost and high reliability.

In some embodiments of the present application, an electrical connecting sheet is provided on the battery module, and the first sampling wire is connected to the electrical connecting sheet by means of welding. The first sampling wire is welded to the electrical connecting sheet of the battery module, which can enable a more reliable connection of the first sampling wire and the battery module, and the welding is also easier to realize, which can improve the installation efficiency of the sampling device.

In some embodiments of the present application, the sampling device further includes a temperature acquisition device, and the second sampling wire is connected to the temperature acquisition device. The temperature acquisition device is configured to acquire a temperature parameter of the battery module, and the second sampling wire is connected to the temperature acquisition device, so that the sampling device can acquire the temperature parameter of the battery module.

In some embodiments of the present application, the second sampling wire is connected to the temperature acquisition device in a plug-in manner. The second sampling wire is plugged into the temperature acquisition device, which can allow the connection and installation of the second sampling wire and the temperature acquisition device to be simple and quick, and also ensure the reliability of connection and fitting and the accuracy of the temperature parameter acquired by the sampling device. In addition, the plug-in connection is a detachable connection, so that the maintenance and replacement of the temperature acquisition device can be facilitated.

In some embodiments of the present application, the sampling circuit board further includes an insulating layer, and the insulating layer is covered on the surfaces of the first sampling wire and the second sampling wire. The insulating layer can prevent potential safety hazards such as short circuit between the first sampling wire and the second sampling wire, and improve the safety performance of the battery. The insulating layer can also protect the surfaces of the first sampling wire and the second sampling wire from corrosion, prolonging the service life of the first sampling wire and the second sampling wire.

In some embodiments of the present application, the sampling circuit board is a flexible flat cable. The flexible flat cable has a light weight and a thin thickness. Therefore, the use of the flexible flat cable can reduce the volume occupied by the sampling device in the battery, thereby reducing the volume and weight of the battery and reducing the cost of the battery. The flexible flat cable also has a good bending and folding property, which can meet its installation under complex spatial structure in the battery.

In a second aspect, an embodiment of the present application provides a battery including a sampling device in any embodiment of the first aspect described above.

In the battery according to the embodiment of the present application, the battery is provided with the sampling device, wherein the sampling circuit board in the sampling device includes the first sampling wire and the second sampling wire, after being connected to the battery module, the first sampling wire and the second sampling wire can acquire different working parameters of the battery module in the battery, and the acquired sampling signals corresponding to the working parameters of the battery module are transmitted to the management system of the battery module via the signal output portion. The battery module various working parameters such as a voltage parameter and a temperature parameter. Accordingly, there are also different requirements for the structural characteristics of the connections of the first sampling wire and the second sampling wire to the battery module to acquire different working parameters of the battery module. When the temperature parameter is required to be acquired, it is required that the connection of a sampling line to the battery module should have oxidation resistance and other characteristics. In the embodiment of the present application, the continuous or discontinuous protective layer is provided on the surface of at least one of the first sampling wire and the second sampling wire, so that at least one of the first sampling wire and the second sampling wire is used for a sampling line for acquiring a temperature signal, and prior to being connected to the battery module, the entire sampling line is protected, thereby forming the protective layer, which can meet the requirement of oxidation resistance for the sampling line, on its surface. Compared with the way of surface treatment only for a connection portion of the sampling line to the battery module, the way of surface treatment for the entire sampling line is not limited by the structure of the connection portion, thereby avoiding the problem of an increased complexity of a treatment process due to the structural limitation of the connection portion. Therefore, the installation of the sampling device is facilitated and the production efficiency of the battery is improved.

In a third aspect, an embodiment of the present application provides a power consuming apparatus including a battery in an embodiment of the second aspect described above.

The above description is only an overview of the technical solutions of the present application. To more clearly understand the technical means of the present application to implement same according to the contents of the description, and to make the above and other objectives, features, and advantages of the present application more obvious and understandable, specific implementations of the present application are exemplarily described below.

### Brief Description of the Drawings

Various other advantages and benefits will become obvious to those of ordinary skill in the art upon reading the following detailed description of preferred implementations. The accompanying drawings are merely for the purpose of illustrating the preferred implementations, and should not be construed as limiting the present application. Moreover, like components are denoted by like reference signs throughout the accompanying drawings. It will be apparent that the drawings described below are merely some embodiments of the present application, and those of ordinary skill in the art may derive other drawings from these drawings without creative efforts. In the drawings:
FIG. 1 is a schematic structure diagram of a vehicle using a battery of an embodiment of the present application;
FIG. 2 is a schematic diagram of a connection structure between a sampling device and a battery module according to some embodiments of the present application; and
FIG. 3 is a schematic structure diagram of a sampling device according to some embodiments of the present application.

Reference signs in the Detailed Description of Embodiments:
1 - Vehicle;
10 - Battery, 20 - Controller, 30 - Motor, 40 - Battery module;
100 - Sampling device, 110 - Sampling circuit board, 111 - First sampling wire, 112 - Second sampling wire, 113 - Signal output portion, 120 - Temperature acquisition device, 130 - Insulating layer, 400 - Battery cell, 410 - Electrical connecting sheet.

### Detailed Description of Embodiments

Embodiments of the technical solutions of the present application will be described in detail below with reference to the accompanying drawings. The following embodiments are merely intended to more clearly illustrate the technical solutions of the present application, so they merely serve as examples, but are not intended to limit the scope of protection of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "include/comprise" and "has/have" and any variations thereof in the description and the claims of the present application as well as the brief description of the accompanying drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description of the embodiments of the present application, the phrase "a plurality of" means two or more, unless otherwise explicitly and specifically defined.

The phrase "embodiment" mentioned herein means that the specific features, structures, or characteristics described in conjunction with the embodiment can be encompassed in at least one embodiment of the present application. The phrase at various locations in the description does not necessarily refer to the same embodiment, or an independent or alternative embodiment exclusive of another embodiment. Those skilled in the art understand explicitly or implicitly that the embodiment described herein may be combined with another embodiment.

In the description of the embodiments of the present application, the term "and/or" is merely intended to describe the associated relationship of associated objects, indicating that three relationships can exist. For example, A and/or B can include: only A exists, both A and B exist, and only B exists. In addition, the character "/" herein generally indicates an "or" relationship between the associated objects.

In the description of the embodiments of the present application, the term "a plurality of" means two or more (including two), similarly the term "a plurality of groups" means two or more groups (including two groups), and the term "a plurality of pieces" means two or more pieces (including two pieces).

In the description of the embodiments of the present application, the orientations or positional relationships indicated by the technical terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientations or positional relationships shown in the accompanying drawings, are merely intended to facilitate and simplify the description of the embodiments of the present application, rather than indicating or implying that the device or element referred to must have a particular orientation or be constructed and operated in a particular orientation, and therefore cannot be construed as limiting the embodiments of the present application.

In the description of the embodiments of the present application, unless otherwise explicitly specified and defined, the technical terms such as "mount", "couple", "connect", and "fix" should be understood in a broad sense. For example, they may be a fixed connection, a detachable connection, or an integrated connection; may be a mechanical connection or an electric connection; and may be a direct connection or an indirect connection by means of an intermediate medium, or may be communication between interiors of two elements or interaction between the two elements. For those of ordinary skill in the art, the specific meanings of the above terms in the embodiments of the present application can be understood according to specific situations.

In the related art, a plurality of groups of traction batteries in a battery system are combined in series and parallel connection to meet certain requirements for voltage and capacity, it is required to acquire voltage, temperature and other information of battery modules of different groups in real time to feed back to a battery management system, so as to protect the charging and discharging of the battery. A sampling device in a battery system usually needs to acquire a variety of information at the same time. Therefore, the sampling device is provided with a plurality of sampling lines to facilitate the acquisition of different working parameters of the battery module. When the working parameters to be acquired are different, the treatment processes of connection portions of the corresponding sampling lines to the battery module are also different. For example, for the sampling line for acquiring a voltage signal, the connection portion thereof to the battery module may be bare metal, facilitating welding to the battery module. However, for the sampling line for acquiring a temperature signal, the connection portion thereof to the battery module needs to be provided with an anti-oxidation layer. It can be seen that different sampling lines need to be treated in different processes at their connection portions, and due to the structural limitation of the connection portion, the complexity of the treatment process will often increase, which will lead to the reduction of the production efficiency of the battery.

Based on the above considerations, in order to simplify the structure of the sampling lines in the sampling device and facilitate their installation, after the in-depth research of the inventor, surfaces of the sampling wires are completely treated in a consistent way to meet the acquisition requirements for different sampling parameters. In this way, no separate local treatment is required for the sampling wire, the structure of the sampling wires in the sampling device is simplified, the problem of an increased process complexity caused by separate treatment of the connection portion is avoided, thereby facilitating the installation of the sampling device and improving the production efficiency of the battery.

An embodiment of the present application provides a power consuming apparatus using a battery as a power supply. The power consuming apparatus may be, but is not limited to, a mobile phone, a tablet, a notebook computer, an electric toy, an electric tool, a battery cart, an electric vehicle, a ship, a spacecraft, etc. The electric toy may include a stationary or mobile electric toy, such as a game console, an electric vehicle toy, an electric ship toy, and an electric airplane toy. The spacecraft may include an airplane, a rocket, a space shuttle, a spaceship, etc.

For ease of description of the embodiments below, an example in which a power consuming apparatus in some embodiments of the present application refers to a vehicle 1 is used for description.

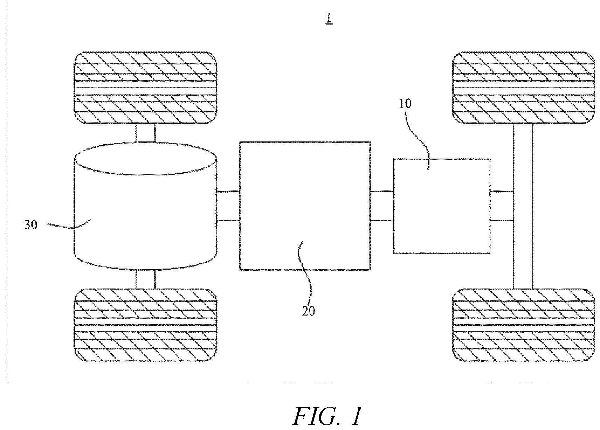

Referring to FIG. 1, FIG. 1 is a schematic structural diagram of a vehicle 1 according to some embodiments of the present application. The vehicle 1 may be a fuel vehicle, a gas vehicle, or a new energy vehicle. The new energy vehicle may be a battery electric vehicle, a hybrid vehicle, an extended-range vehicle, etc. A battery 10 is provided inside the vehicle 1, and the battery 10 may be arranged at the bottom, the front or the back of the vehicle 1. The battery 10 may be configured to supply power to the vehicle 1. For example, the battery 10 may be used as a power supply for operating the vehicle 1. The vehicle 1 may further include a controller 20 and a motor 30. The controller 20 is configured to control the battery 10 to supply power to the motor 30, for example, to meet working power requirements during starting, navigation, and traveling of the vehicle 1. In another embodiment of the present application, the battery 10 can not only serve as a power supply for operating the vehicle 1, but also serve as a power supply for driving the vehicle 1, instead of or partially instead of fuel or natural gas, to provide driving power for the vehicle 1.

The battery 10 mentioned in the embodiments of the present application refers to a single physical module including one or more battery cells 400 to provide a higher voltage and capacity. The battery 10 generally includes a case for packaging one or more battery cells. The case can prevent liquid or other foreign matter from affecting charging or discharging of the battery cell(s). Exemplarily, the case may include an upper cover and a casing. The upper cover and the casing are fitted together. The upper cover and the casing may be shaped depending on a shape of a combination of the plurality of battery cells 400.

The plurality of battery cells 400 may be connected in series and/or in parallel via terminal posts for various application scenarios. In some high-power application scenarios such as an electric vehicle, the use of the battery includes three levels: a battery cell, a battery module and a battery pack. The battery module is formed by electrically connecting a number of battery cells together and putting the battery cells into a frame in order to protect the battery cells from external shocks, heat, vibration, etc. The battery pack is a final state of a battery system mounted in the electric vehicle. The battery pack generally includes a case configured to package one or more battery cells. The case can prevent liquid or other foreign matter from affecting charging or discharging of the battery cell(s). The case is generally composed of a cover and a casing. Most of the current battery packs are manufactured by assembling various control and protection systems such as a battery management system (BMS) and a thermal management component on one or more battery modules. With the development of technologies, the level of the battery module may be omitted. That is, the battery pack is directly formed by the battery cells. With this improvement, the number of parts is remarkably reduced while a weight energy density and a volume energy density of the battery system are improved. The battery mentioned in the present application includes a battery module or a battery pack.

In the present application, the battery cell 400 may include a lithium-ion secondary battery, a lithium-ion primary battery, a lithium-sulfur battery, a sodium/lithium ion battery, a sodium-ion battery or a magnesium-ion battery, etc., which is not limited in the embodiment of the present application. The battery cell may be cylindrical, flat, cuboid or in another shape, which is also not limited in the embodiment of the present application. The battery cells are generally classified into three types depending on the way of package: cylindrical battery cells, prismatic battery cells and pouch battery cells, which is also not limited in the embodiment of the present application.

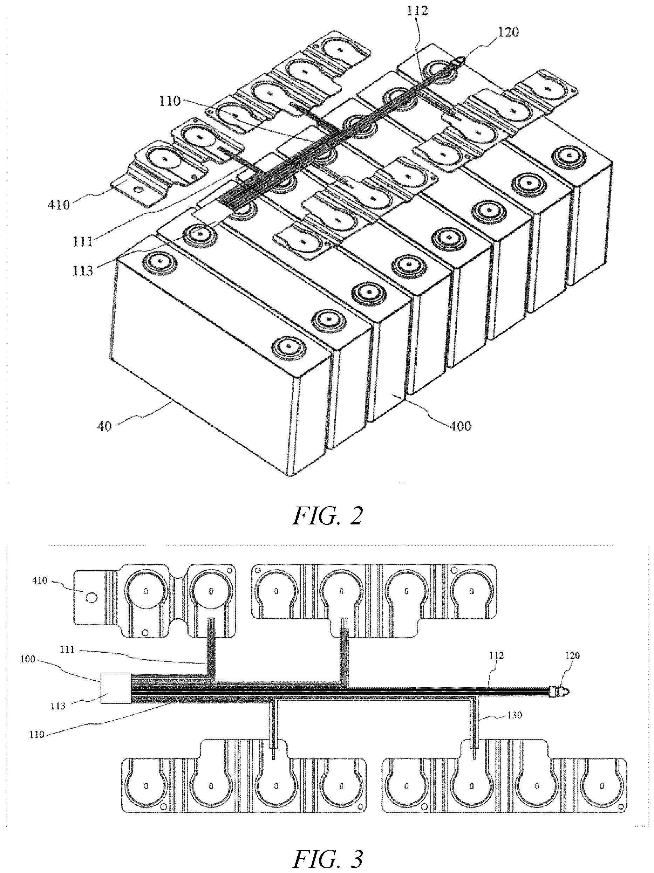

Referring to FIG. 2, the plurality of battery cells 400 may be connected in series or in parallel to form a battery module 40. The battery 10 may include a plurality of battery modules 40, and the plurality of battery modules 40 may be connected in series or in parallel. An electrical connecting sheet 410 is provided on the battery module 40, and the electrical connecting sheet 410 is connected to terminal posts of the plurality of battery cells 400. The battery cell 400 may be a secondary battery or a primary battery, or may be a lithium-sulfur battery, a sodium-ion battery, or a magnesium-ion battery, which is not particularly limited in the present application. The battery cell 400 may be cylindrical, flat, cuboid or in another shape. The battery module 40 may also be formed by the plurality of battery cells 400 in parallel-series connection. The parallel-series connection means that some of the plurality of battery cells 400 are connected in series and some are connected in parallel. The electrical connecting sheet 410 is a device for transmitting current. The electrical connecting sheet 410 may be rectangular, trapezoidal, triangular, stepped, etc., and the electrical connecting sheet 410 may be made of nickel-plated copper, pure nickel strap, nickel-plated steel, etc., which are not particularly limited in the present application.

Referring to FIGS. 2 and 3, in a first aspect, an embodiment of the present application provides a sampling device100. The sampling device100 includes a sampling circuit board 110. The sampling circuit board 110 has a first sampling wire 111 and a second sampling wire 112, wherein the first sampling wire 111 and the second sampling wire 112 are configured to acquire different working parameters of the battery module 40, a continuous or discontinuous protective layer is provided on a surface of at least one of the first sampling wire 111 and the second sampling wire 112, a signal output portion 113 is provided on the sampling circuit board 110, and the first sampling wire 111 and the second sampling wire 112 are both connected to the signal output portion 113.

The sampling device 100 is a device for acquiring sampling signals of the battery module 40 or the battery cell 400 and transmitting the sampling signals to the battery management system. The sampling signals are electrical signals representing the working parameters of the battery module 40 or the battery cell 400, such as pressure signals, temperature signals, and internal resistance signals.

The sampling circuit board 110 is a circuit board with built-in sampling lines. The sampling lines are various cables that can transmit electrical signals, and a plurality of sampling lines are integrated to form the sampling circuit board 110. It can be understood that the sampling circuit board 110 may also be provided with an auxiliary structure for fixing or supporting the sampling lines.

The first sampling wire 111 is one of the sampling lines described above. Similarly, the second sampling wire 112 is also one of the sampling lines described above. The first sampling wire 111 and the second sampling wire 112 are configured to acquire different working parameters, that is, the sampling signals acquired by the two are different.

The protective layer is a layer structure having oxidation resistance and corrosion resistance and formed on a surface of the sampling line. The purpose of providing the protective layer is to prolong the service life of the sampling line.

The signal output portion 113 is a structure on the sampling circuit board 110 for outputting the sampling signals. The first sampling wire 111 and the second sampling wire 112 are both connected to the signal output portion 113, so that the sampling signals acquired by the first sampling wire 111 and the second sampling wire 112 are output via the signal output portion 113. Exemplarily, the signal output portion 113 may be a signal output interface, and when the signal output interface is connected to the battery management system, the sampling signals can be transmitted to the battery management system via the signal output portion 113.

In the sampling device 100 according to the embodiment of the present application, the sampling circuit board 110 of the sampling device includes the first sampling wire 111 and the second sampling wire 112, after being connected to the battery module 40, the first sampling wire 111 and the second sampling wire 112 can acquire different working parameters of the battery module 40, and the acquired sampling signals corresponding to the working parameters of the battery module 40 are transmitted to a management system of the battery module 40 via the signal output portion 113. The battery module 40 has various working parameters such as a voltage parameter, a temperature parameter. Accordingly, there are also different requirements for the structural characteristics of the connections of the first sampling wire 111 and the second sampling wire 112 to the battery module 40 to acquire different working parameters of the battery module 40. When the temperature parameter is required to be acquired, it is required that the connection of a sampling line to the battery module 40 should have oxidation resistance and other characteristics. In the embodiment of the present application, the continuous or discontinuous protective layer is provided on the surface of at least one of the first sampling wire 111 and the second sampling wire 112, so that at least one of the first sampling wire 111 and the second sampling wire 112 includes a sampling line for acquiring a temperature signal, and prior to being connected to the battery module 40, the entire sampling line is protected, thereby forming the protective layer, which can meet the requirement of oxidation resistance for the sampling line, on its surface. Compared with the way of surface treatment only for a connection portion of the sampling line to the battery module 40, the way of surface treatment for the entire sampling line is not limited by the structure of the connection portion, thereby avoiding the problem of an increased complexity of a treatment process due to the structural limitation of the connection portion. Therefore, the installation of the sampling device is facilitated and the production efficiency of the battery is improved.

In some embodiments of the present application, the first sampling wire 111 is configured to acquire a voltage signal of the battery module 40, and the first sampling wire 111 is a bare metal wire.

The bare metal wire refers to a metal wire without an insulating material covered on a surface, such as a bare copper wire, a bare aluminum wire or a bare nickel alloy wire. The bare metal wire has good electrical conductivity and physical and mechanical properties.

Since the first sampling wire 111 is configured to acquire the voltage signal of the battery module 40, the first sampling wire 111 is often electrically connected to the battery module 40 by means of welding, and for the convenience of welding, the entire first sampling wire 111 may be a bare metal wire without surface treatment. In some cases, the sampling line for acquiring the voltage signal is also required to have oxidation resistance. In this case, the entire bare metal wire may also be shot peened to form an anti-oxidation layer on the surface of the bare metal wire.

In some embodiments of the present application, the second sampling wire 112 is configured to acquire a temperature signal of the battery module 40, and the protective layer is provided on the surface of the second sampling wire 112. In the related art, the sampling line for acquiring the temperature signal is required to have oxidation resistance. Since the second sampling wire 112 is configured to acquire the temperature signal of the battery module 40, the protective layer is provided on the surface of the second sampling wire 112 to improve the oxidation resistance of the second sampling wire 112.

In some embodiments of the present application, the protective layer is a tin-plated layer or a gold-plated layer.

The tin-plated layer or the gold-plated layer refers to a thin layer of tin metal or gold plated on a surface of a bare metal wire (for example, a bare copper wire). The process of tin plating and gold plating has low cost and high reliability, can make a copper wire more resistant to corrosion and oxidation, and can greatly prolong the service life of the copper wire.

In some embodiments of the present application, an electrical connecting sheet 410 is provided on the battery module 40, and the first sampling wire 111 is connected to the electrical connecting sheet 410 by means of welding.

The electrical connecting sheet 410 is configured for connection to terminal posts of the battery cells 400 in the battery module 40, so that the battery cells 400 are connected in series or in parallel. The electrical connecting sheet 410 may be rectangular, trapezoidal, triangular, stepped, etc., and the electrical connecting sheet 410 may be made of nickel-plated copper, pure nickel strap, nickel-plated steel, etc., which are not particularly limited in the present application.

The first sampling wire 111 is welded to the electrical connecting sheet 410, which can enable a more reliable connection between the first sampling wire 111 and the electrical connecting sheet 410. In addition, the welding connection manner is simple and efficient, which can improve the installation efficiency of the sampling device 100.

In some embodiments of the present application, the sampling device 100 further includes a temperature acquisition device 120, and the second sampling wire 112 is connected to the temperature acquisition device 120.

The temperature acquisition device 120 is a device including means such as a temperature sensor and a control module, and the temperature acquisition device 120 has a function of temperature acquisition.

The second sampling wire 112 is connected to the temperature acquisition device 120, so that the sampling device 100 can acquire the temperature parameter of the battery module 40.

In some embodiments of the present application, the second sampling wire 112 is connected to the temperature acquisition device 120 in a plug-in manner. The temperature acquisition device 120 is provided with a plug-in interface, and the second sampling wire 112 is fitted to the plug-in interface of the temperature acquisition device 120 in a plug-in manner, which can allow the connection and installation of the second sampling wire 112 and the temperature acquisition device 120 to be simple and quick, and also ensure the reliability of connection and fitting and the accuracy of the temperature parameter acquired by the sampling device 100. In addition, the plug-in connection is a detachable connection, so that the maintenance and replacement of the temperature acquisition device 120 can be facilitated.

In some embodiments of the present application, the sampling circuit board 110 further includes an insulating layer 130, and the insulating layer 130 is covered on the surfaces of the first sampling wire 111 and the second sampling wire 112.

The insulating layer 130 is a layer of non-conductive material evenly and hermetically wrapped around a wire. The insulating layer 130 may be made of resin, plastic, silicone rubber, PVC, etc. The insulating layer 130 can prevent the wire from contacting with the outside which causes accidents such as electric leakage, short circuit, or electric shock. The insulating layer 130 is covered on the surfaces of the first sampling wire 111 and the second sampling wire 112, which improves the safety performance of the battery 10.

In some embodiments of the present application, the sampling circuit board 110 is a flexible flat cable. The flexible flat cable is a new type of data cable produced by pressing together an insulating material of polyethylene terephthalate with extremely thin tin-plated flat copper wires using the production line of high-tech automated apparatus, and has the advantages of softness, arbitrary bending and folding, thin thickness, small volume, simple connection, convenient disassembly and easy solution of electromagnetic shielding.

The application of the flexible flat cable in the sampling device 100 can reduce the volume occupied by the sampling device 100 in the battery 10, thereby reducing the volume and weight of the battery 10 and saving the cost. The flexible flat cable also has a good bending and folding property, which can meet its installation under complex spatial structure in the battery 10.

According to some embodiments of the present application, the sampling device 100 includes a sampling circuit board 110. The sampling circuit board 110 has a first sampling wire 111 and a second sampling wire 112, and the first sampling wire 111 and the second sampling wire 112 are configured to acquire different working parameters of a battery module 40, wherein the first sampling wire 111 is configured to acquire a voltage signal of the battery module 40, the second sampling wire 112 is configured to acquire a temperature signal of the battery module 40, the first sampling wire 111 is a bare copper wire and is welded to an electrical connecting sheet 410 of the battery module 40, the second sampling wire 112 is a copper wire with a tin-plated or gold-plated surface, the second sampling wire 112 is connected to a temperature acquisition device 120 of the sampling device 100 in a plug-in manner, and the first sampling wire 111 and the second sampling wire 112 are both connected to a signal output portion 113 on the sampling circuit board 110.

In the sampling device 100 according to the embodiment of the present application, the sampling circuit board 110 of the sampling device includes the first sampling wire 111 and the second sampling wire 112, after being connected to the battery module 40, the first sampling wire 111 and the second sampling wire 112 can acquire different working parameters of the battery module 40, and the acquired sampling signals corresponding to the working parameters of the battery module 40 are transmitted to a management system of the battery module 40 via the signal output portion 113. The battery module 40 has various working parameters such as a voltage parameter, a temperature parameter. Accordingly, there are also different requirements for the structural characteristics of the connections of the first sampling wire 111 and the second sampling wire 112 to the battery module 40 to acquire different working parameters of the battery module 40. When the temperature parameter is required to be acquired, it is required that the connection of a sampling line to the battery module 40 should have oxidation resistance and other characteristics. In the embodiment of the present application, the continuous or discontinuous protective layer is provided on the surface of at least one of the first sampling wire 111 and the second sampling wire 112, so that at least one of the first sampling wire 111 and the second sampling wire 112 is used for a sampling line for acquiring a temperature signal, and prior to being connected to the battery module 40, the entire sampling line is protected, thereby forming the protective layer, which can meet the requirement of oxidation resistance for the sampling line, on its surface. Compared with the way of surface treatment only for a connection portion of the sampling line to the battery module, the way of surface treatment for the entire sampling line is not limited by the structure of the connection portion, thereby avoiding the problem of an increased complexity of a treatment process due to the structural limitation of the connection portion. Therefore, the installation of the sampling device is facilitated and the production efficiency of the battery is improved.

In addition, since the first sampling wire 111 is configured to acquire the voltage signal of the battery module 40, the first sampling wire 111 is electrically connected to the battery module 40 by means of welding, and for the convenience of welding, the first sampling wire 111 may be a bare copper wire without surface treatment. Since the second sampling wire 112 is configured to acquire the temperature signal of the battery module 40, the protective layer is provided on the surface of the second sampling wire 112 to improve the oxidation resistance of the second sampling wire 112.

In a second aspect, an embodiment of the present application provides a battery 10 including a sampling device 100 in any embodiment of the first aspect described above.

In the battery 10 according to the embodiment of the present application, the battery is provided with the sampling device 100, wherein the sampling circuit board 110 in the sampling device 100 includes the first sampling wire 111 and the second sampling wire 112, after being connected to the battery module 40, the first sampling wire 111 and the second sampling wire 112 can acquire different working parameters of the battery module 40 in the battery 10, and the acquired sampling signals corresponding to the working parameters of the battery module 40 are transmitted to the management system of the battery module 40 via the signal output portion 113. The battery module 40 has various working parameters such as a voltage parameter, a temperature parameter. Accordingly, there are also different requirements for the structural characteristics of the connections of the first sampling wire 111 and the second sampling wire 112 to the battery module 40 to acquire different working parameters of the battery module 40. When the temperature parameter is required to be acquired, it is required that the connection of a sampling line to the battery module 40 should have oxidation resistance and other characteristics. In the embodiment of the present application, the continuous or discontinuous protective layer is provided on the surface of at least one of the first sampling wire 111 and the second sampling wire 112, so that at least one of the first sampling wire 111 and the second sampling wire 112 includes a sampling line for acquiring a temperature signal, and prior to being connected to the battery module 40, the entire sampling line is protected, thereby forming the protective layer, which can meet the requirement of oxidation resistance for the sampling line, on its surface. Compared with the way of surface treatment only for a connection portion of the sampling line to the battery module, the way of surface treatment for the entire sampling line is not limited by the structure of the connection portion, thereby avoiding the problem of an increased complexity of a treatment process due to the structural limitation of the connection portion. Therefore, the installation of the sampling device is facilitated and the production efficiency of the battery is improved.

In a third aspect, an embodiment of the present application provides a power consuming apparatus including a battery 10 in an embodiment of the second aspect described above.

Since the power consuming apparatus in the embodiment of the present application and the battery 10 in the embodiment of the second aspect described above are based on the same inventive concept, the power consuming apparatus in the embodiment of the present application can obtain all the beneficial effects of the battery 10 in the embodiment of the second aspect described above.

It should be finally noted that, the above embodiments are merely used for illustrating rather than limiting the technical solutions of the present application. Although the present application has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the present application, and should fall within the scope of the claims and the description of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A sampling device (100), **characterized by** comprising:
a sampling circuit board having a first sampling wire and a second sampling wire, wherein the first sampling wire and the second sampling wire are configured to acquire different working parameters of a battery module, a continuous or discontinuous protective layer is provided on a surface of at least one of the first sampling wire and the second sampling wire, a signal output portion is provided on the sampling circuit board, and the first sampling wire and the second sampling wire are both connected to the signal output portion.

2. The sampling device according to claim 1, **characterized in that** the first sampling wire is configured to acquire a voltage signal of the battery module, and the first sampling wire is a bare metal wire.

3. The sampling device according to claim 2, **characterized in that** an anti-oxidation layer is provided on the surface of the bare metal wire.

4. The sampling device according to any one of claims 1 to 3, **characterized in that** the second sampling wire is configured to acquire a temperature signal of the battery module, and the protective layer is provided on the surface of the second sampling wire.

5. The sampling device according to claim 4, **characterized in that** the protective layer is a tin-plated layer or a gold-plated layer.

6. The sampling device according to claim 2, **characterized in that** an electrical connecting sheet is provided on the battery module, and the first sampling wire is connected to the electrical connecting sheet by means of welding.

7. The sampling device according to claim 4, **characterized in that** the sampling device further comprises a temperature acquisition device, and the second sampling wire is connected to the temperature acquisition device.

8. The sampling device according to claim 7, **characterized in that** the second sampling wire is connected to the temperature acquisition device in a plug-in manner.

9. The sampling device according to any one of claims 1 to 8, **characterized in that** the sampling circuit board further comprises an insulating layer, and the insulating layer is covered on the surfaces of the first sampling wire and the second sampling wire.

10. The sampling device according to claim 9, **characterized in that** the sampling circuit board is a flexible flat cable.

11. A battery, **characterized by** comprising a sampling device according to any one of claims 1 to 10.

12. A power consuming apparatus, **characterized by** comprising a battery according to claim 11.
